# EUROPEAN PATENT SPECIFICATION

(11) **EP 2 417 873 B1**
(45) Date of publication and mention of the grant of the patent: **11.09.2013**
(21) Application number: 11175273.9
(22) Date of filing: 26.07.2011
(51) Int. Cl.: H05K 7/14

(54) **Slide assembly**
Schiebeanordnung
Ensemble coulissant

(30) Priority: 09.08.2010 TW 099126559
(43) Date of publication of application: 15.02.2012
(73) Proprietor: King Slide Works Co., Ltd., Kaohsiung City (TW)
(72) Inventor: Chen, Ken-Ching, Kaohsiung City (TW); Wang, Chun-Chiang, Kaohsiung City (TW)
(74) Representative: Viering, Jentschura & Partner

(56) References cited:
- EP-A1- 2 123 193
- EP-A1- 2 133 006
- US-B1- 6 601 933

## Description

### FIELD OF THE INVENTION

The present invention relates to a slide assembly, and more particularly, to a slide assembly which is easily installed and has reinforced structure, the slide assembly is quickly installed to chasses.

### BACKGROUND OF THE INVENTION

In a conventional computer system, a server is mounted on a chassis and two rails are connected to two sides of the chassis, wherein the chassis is supported by the rails and brackets so as to be mounted to a four-post rack. The server can be pulled out from the rack by the rails and the carriages cooperated therewith for convenience of maintenance.

U.S. Patent No. 6,209,979 discloses a telescoping slide assembly which includes multiple L-shaped holes defmed in the tops of the rails and multiple hooks are connected to two sides of the chassis, so that the hooks are engaged with the L-shaped holes to position the rails. A stop plate covers one of the L-shaped holes so that the chassis can be quickly installed to the rails on the rack.

Some similar designs are disclosed in U.S. Patent No. 6,601,933, 6,938,967 and 7,382,623 which are provided for reference.

Further the documents EP 2 123 193, US 6 601 933, EP 2 133 006 show known slide assemblies.

Generally, the room for the chassis in the rack is limited so that the chassis cannot be pulled horizontally out together with a part of the rails, so that the improved designs allow the chassis to be detached perpendicularly from the rails after the chassis and part of the rails are horizontally pulled out from the cabinet.

However, the rails have to include holes defined from the top to the central portion thereof so as to achieve the purpose of the perpendicular pull-out action. Therefore, the area at the position where the holes are drilled of the rails is reduced and this causes the weak structure for the rails and the ability for carrying heavy chassis.

In addition, because the limitation of the size of the rack and the distance between the posts from the common requirements of the industry, the rails have to be made as thin as possible so as to allow the chassis to have maximum inner space. Under such requirements, the thin rails severely challenge the structural strength so that the holes defined from the top to the central portion of the rails are not an ideal option.

Furthermore, the gap between the rails becomes smaller along with the use of thinner rails and the hooks on the two sides of the chassis are inserted into the holes. The thickness of the hooks is fixed and/or cannot be changed because of the requirement of strength. Therefore, how to obtain a sufficient room between the hooks and the holes becomes one of the concerns in this industry.

### SUMMARY OF THE INVENTION

The present invention intends to provide a slide assembly which has reinforced strength and the chassis can be quickly installed to the slide assembly.

According to one aspect of the present invention, a slide assembly includes an outer rail, an inner rail and a stop plate. The inner rail is longitudinally and slidably movable relative to the outer rail. The inner rail has a top flange and a bottom flange which is located opposite to the top flange. A connection wall is connected between the top and bottom flanges. At least two engaging portions are located in the inner rail and each having a hole defined in the connection wall of the inner rail. A recessed inner wall is defined in the inner rail and extends from the hole to the top flange. The stop plate is connected to inside of the connection wall of the inner rail and has a stop portion which is located corresponding to the hole of one of the engaging portions.

According to another aspect of the present invention, a slide assembly is adapted to an installation system for installing a chassis to the rack. The chassis has a plurality of installation members on two sides thereof. The sliding assembly comprises an outer rail and an inner rail which is longitudinally and slidably movable relative to the outer rail. The inner rail has a top flange and a bottom flange which is located opposite to the top flange. A connection wall is connected between the top and bottom flanges. A plurality of engaging portions are located in the inner rail and each has a hole defined in the connection wall of the inner rail. A recessed inner wall is defined in the inner rail and extends from the hole to the top flange. The connection wall of the inner rail includes a plurality of recesses, each recess is located corresponding to the hole of one of the engaging portions. Each installation member has a head and a neck protruding from one of the two sides of the chassis.

Preferably, the head of the installation member of the chassis is engaged with the hole of the inside of the connection wall via the recessed inner wall of the inner rail. The head is partially inserted into the recess.

Preferably, a middle rail is movably connected between the inner and outer rails. A first carriage is movably connected between the middle rail and the inner rail. A first ball assembly is connected to the first carriage. A second carriage is movably connected between the middle rail and the outer rail. A second ball assembly is connected to the second carriage. The top flange of the inner rail has a first section and a first bent portion. The bottom flange of the inner rail has a second section and a second bent portion. The first ball assembly of the first carriage is movably between the first bent portion of the top flange and the second bent portion of the bottom flange.

Preferably, a stop plate is connected to the inside of the connection wall of the inner rail and located corresponding to one of the engaging portions of the inner rail. The stop plate has a stop portion which is located corresponding to the hole of one of the engaging portions.

Preferably, the head of the installation member of the chassis is engaged with the hole of the inner rail and stopped by the stop portion of the stop plate so as to be positioned to the engaging portion of the inner rail.

Preferably, the stop plate further includes a guiding portion which is located corresponding to the recessed inner wall.

The present invention will become more obvious from the following description when taken in connection with the accompanying drawings which show, for purposes of illustration only, a preferred embodiment in accordance with the present invention.

### BRIEF DESCRIPTION OF THE DRAWINGS

Fig. 1 shows the installation of a chassis in the slide assembly according to a first embodiment of the present invention;
Fig. 2 shows the installation of the chassis in an inner rail of the slide assembly according to the first embodiment of the present invention;
Fig. 3 shows a cross sectional view of the slide assembly according to the first embodiment of the present invention;
Fig. 4 shows the outside of the inner rail of the slide assembly according to the first embodiment of the present invention;
Fig. 5 shows the inside of the inner rail of the slide assembly according to the first embodiment of the present invention;
Fig. 6 shows the inner rail and the stop plate of the slide assembly according to the first embodiment of the present invention;
Fig. 7 shows that the stop plate is installed to the inner rail of the slide assembly according to the first embodiment of the present invention;
Fig. 8 shows the way that the installation member of the chassis is installed to the inner rail of the slide assembly according to the first embodiment of the present invention;
Fig. 9 shows that the installation member of the chassis is installed to the inner rail of the slide assembly according to the first embodiment of the present invention;
Fig. 10 shows that the stop plate is pulled so that the installation member is disengaged from the inner rail according to the first embodiment of the present invention;
Fig. 11 shows the position relationship between the installation member and the engaging portion of the inner rail according to the first embodiment of the present invention;
Fig. 12 shows the position relationship between the installation member, inner rail and the middle rail according to the first embodiment of the present invention;
Fig. 13 shows the inner rail and the stop plate according to a second embodiment of the present invention, and
Fig. 14 shows the holes of the inner rail according to the second embodiment of the present invention.

### DETAILED DESCRIPTION OF THE PREFERRED EMBODIMENT

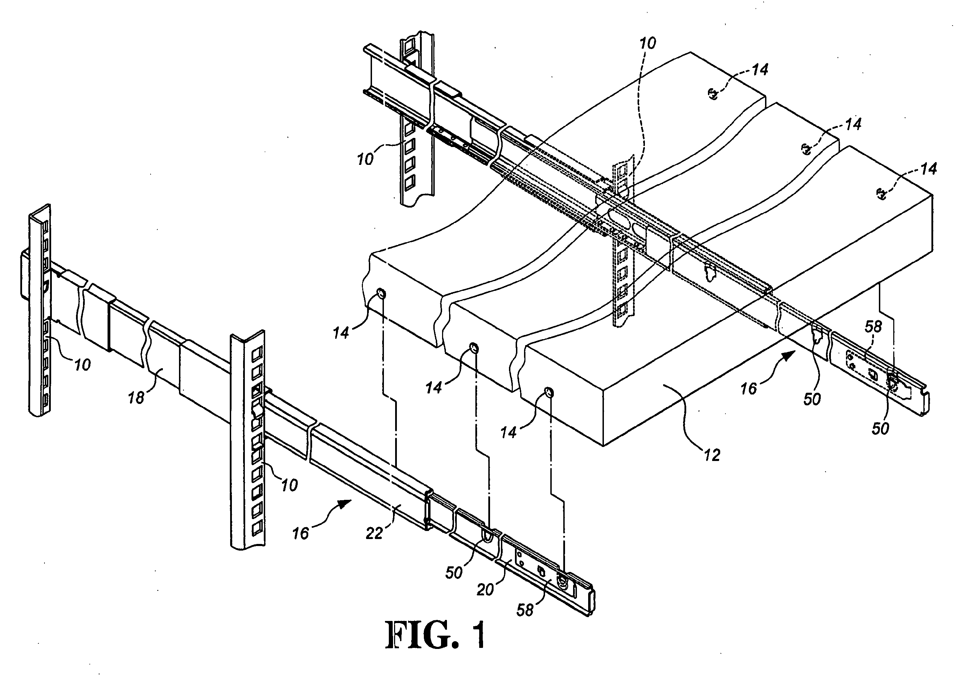

Fig. 1 shows four posts 10 of a rack (not shown), a chassis 12, a plurality of installation members 14 fixed to two sides of the chassis 12 and at least two slide assemblies 16 connected to the front and rear posts 10 on each side. Each slide assembly 16 of the present invention comprises an outer rail 18 and an inner rail 20 which is longitudinally and slidably movable relative to the outer rail 18. Preferably, a middle rail 22 is movably connected between the inner and outer rails 20, 18 so that the inner rail 20 can be pulled a longer distance relative to the outer rail 18.

In this embodiment, the installation members 14 on the two sides of the chassis 12 are connected to the inner rails 20 on the two sides of the posts 10 so that the chassis 12 can be pushed in or pulled out by the slide assemblies 16.

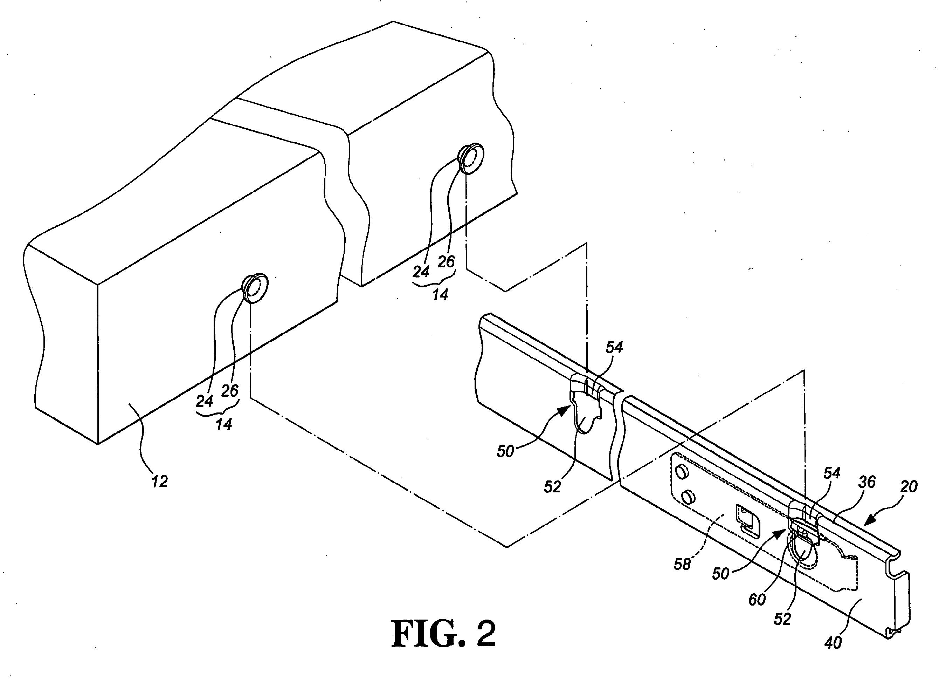

Referring to Fig. 2, each installation member 14 protruding from the side of the chassis 12 includes a neck 24 and a head 26, wherein the diameter of the head 26 is larger than that of the neck 24.

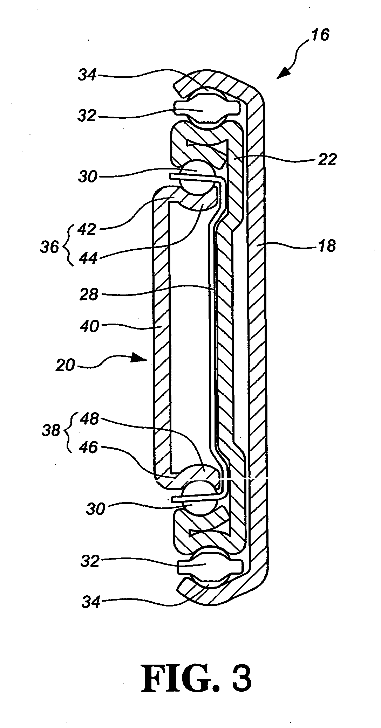

Referring to Fig. 3, the slide assembly 16 further has a first carriage 28 movably connected between the middle rail 22 and the inner rail 20. A first ball assembly 30 is connected to the first carriage 28 so that the middle rail 22 and the inner rail 20 are easily moved by the operation of the first ball assembly 30. A second carriage 32 is movably connected between the middle rail 22 and the outer rail 18. A second ball assembly 34 is connected to the second carriage 32 so that the outer rail 18 and the middle rail 22 are easily moved by the operation of the second ball assembly 34. This forms a three-stage telescoping sliding assembly. If it is a two-stage telescoping sliding assembly, only one carriage is needed to be movably connected between the outer rail 18 and the inner rail 20, and one ball assembly needs to be connected to the carriage to achieve the purpose of movement mentioned above.

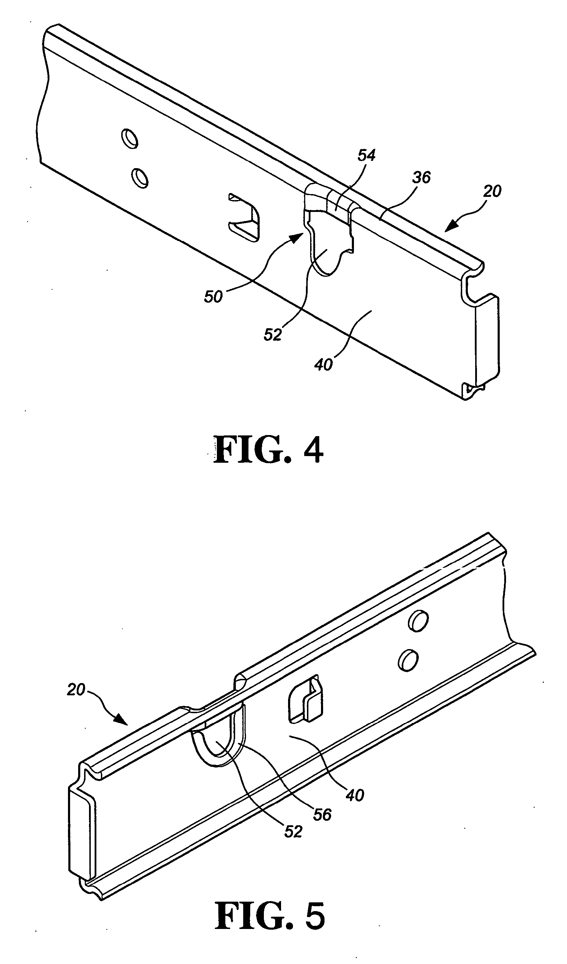

In this embodiment, the inner rail 20 includes a top flange 36 and a bottom flange 38 which is located opposite to the top flange 36. A connection wall 40 is connected between the top and bottom flanges 36, 38. The top flange 36 of the inner rail 20 has a first section 42 and a first bent portion 44 which is the top groove for the balls. The bottom flange 38 of the inner rail 20 has a second section 46 and a second bent portion 48 which is the bottom groove for the balls. The first bent portion 44 of the top flange 36 and the second bent portion 48 of the bottom flange 38 are used as a rolling track of the first ball assembly 30 of the first carriage 28. Referring to Figs. 2, 4, a plurality of engaging portions 50 are located in the inner rail 20 and each engaging portion 50 has a hole 52 defined in the connection wall 40 of the inner rail 20. A recessed inner wall 54 is defined in the inner rail 20 and extends from the hole 52 to the top flange 36. Preferably, the recessed inner wall 54 perpendicularly extends from the first section 42 of the top flange 36 of the inner rail 20 to a part of the connection wall 40 of the inner rail 20. As shown in Fig. 5, in a preferable embodiment, a plurality of recesses 56 are defined and located corresponding to the engaging portions 50 respectively and each recess 56 is defined in the inside of the connection wall 40 of the inner rail 20 and extends along the periphery of the hole 52.

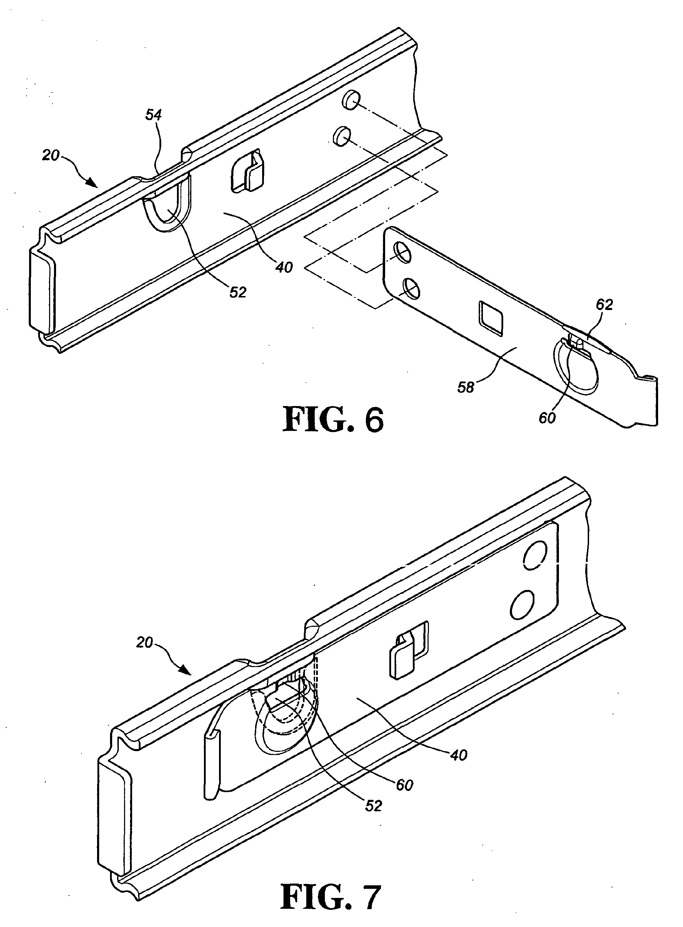

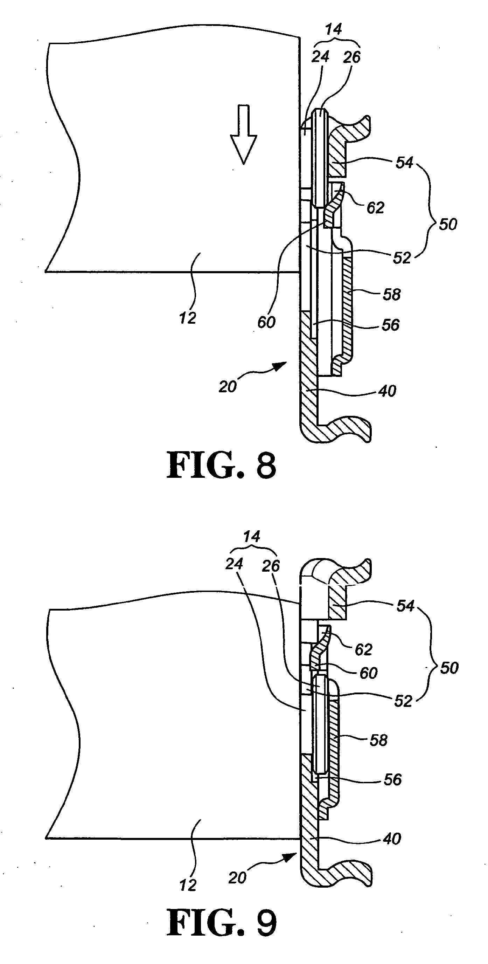

As shown in Figs. 6 and 7, a stop plate 58 is connected to the inside of the connection wall 40 of the inner rail 20 and has a stop portion 60 which is located corresponding to the hole 52 of one of the engaging portions 50. The stop plate 58 restricts an object such as the installation member 14 as shown in Fig. 9 to connect the object to the inner rail 20. The stop plate 58 includes a guiding portion 62 which is located corresponding to the recessed inner wall 54.

When assembling the chassis 12 to the slide assemblies 16 on the posts 10 as shown in Figs. 1, 8 and 9, the installation members 14 on the chassis 12 are in alignment with the engaging portions 50 of the inner rails 20 so that the heads 26 of the installation members 14 are engaged with the inside of the connection wall 40 downward via the recessed inner walls 54 of the inner rail 20 and the guiding portion 62 of the stop plate 58 can be pushed by one of the heads 26 of the installation members 14, then the heads 26 of the installation members 14 slide into the holes 52. The head 26 of each of the installation members 14 hooks the inside of the connection wall 40 where the hole 52 is located. The head 26 of each of the installation members 14 is partially inserted into the recess 56. The stop portion 60 of the stop plate 58 stops the head 26 of the installation member 14 so that the installation member 14 is firmly connected to the hole 52 of the inner rail 20. By this way, at least two installation members 14 on the two sides of the chassis 12 are installed to the corresponding engaging portions 50 of the inner rails 20 and the chassis 12 is connected to the slide assemblies 16 on the posts 10 to form the telescoping mechanism for the chassis 12.

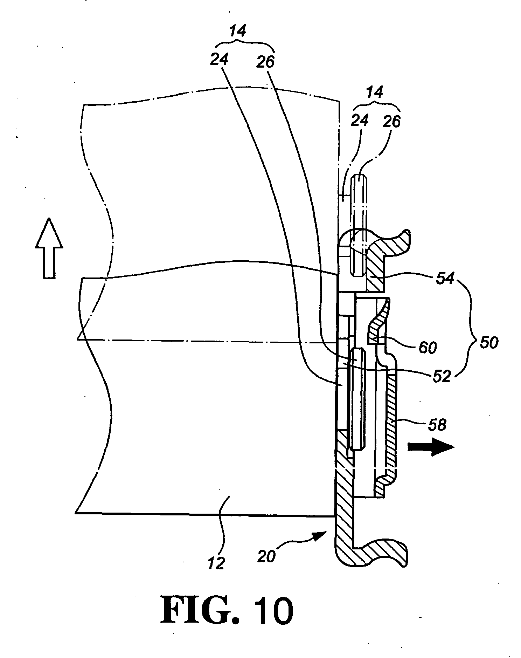

Fig. 10 shows that the installation member 14 is removed from the engaging portion 50 of the inner rail 20 by pulling the stop plate 58 away from the inner rail 20. The stop portion 60 of the stop plate 58 does not stop the head 26 of the installation member 14 such that the installation member 14 can be removed from the hole 52 of the inner rail 20 and disengaged from the inner rail 20 upwardly from the recessed inner wall 54.

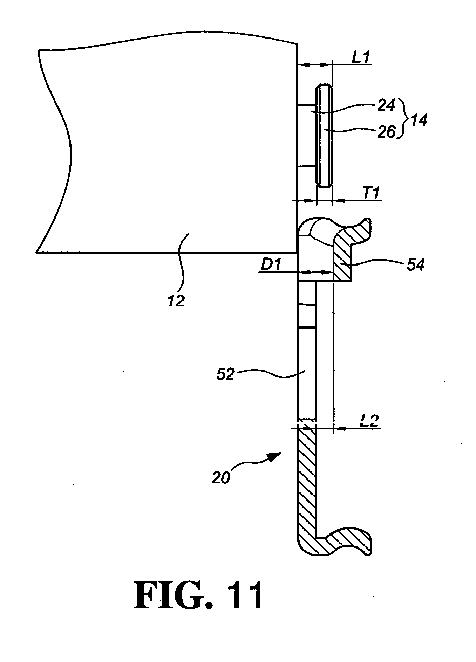

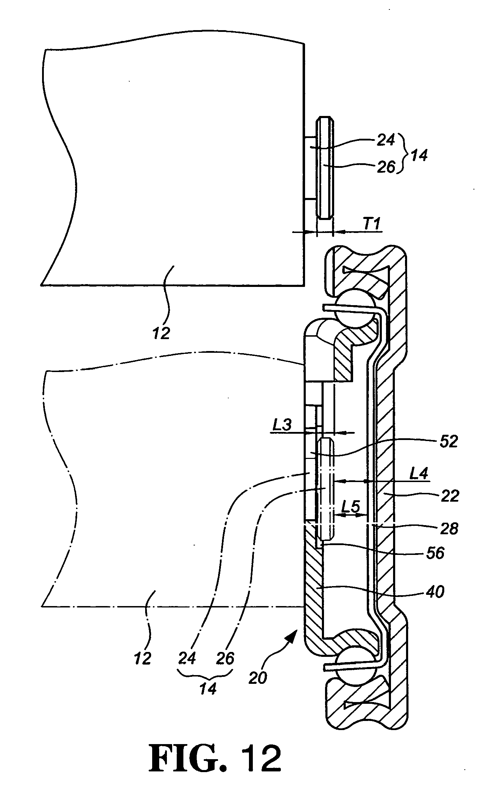

In a preferable embodiment as shown in Fig. 11, the depth D1 of the recessed inner wall 54 is equal to the distance L1 from the head 26 protruding from the chassis 12 to the neck 24. The head 26 of the installation member 14 can be slid downward from the recessed inner wall 54 and engaged with the hole 52 located at the inside of the connection wall 40. The distance L2 from the recessed inner wall 54 to the inside of the connection wall 40 is equal to the thickness T1 of the head 26 of the installation member 14. If the peripheral of the inside of the hole 52 of the connection wall 40 has a recess 56 as shown in Fig. 12, the distance L3 from the recessed inner wall 54 to the inside of the recess 56 is equal to the thickness T1 of the head 26 of the installation member 14. Therefore, the head 26 protruding from the inside of the connection wall 40 is reduced and this means that the distance L4 from the head 26 to the middle rail 22 is increased. If the first carriage 28 is connected between the middle rail 22 and the inner rail 20, the distance L5 from the head 26 to the first carriage 28 is increased so that the available room between the inner rail 20 to the middle rail 22 or the first carriage 28 is increased.

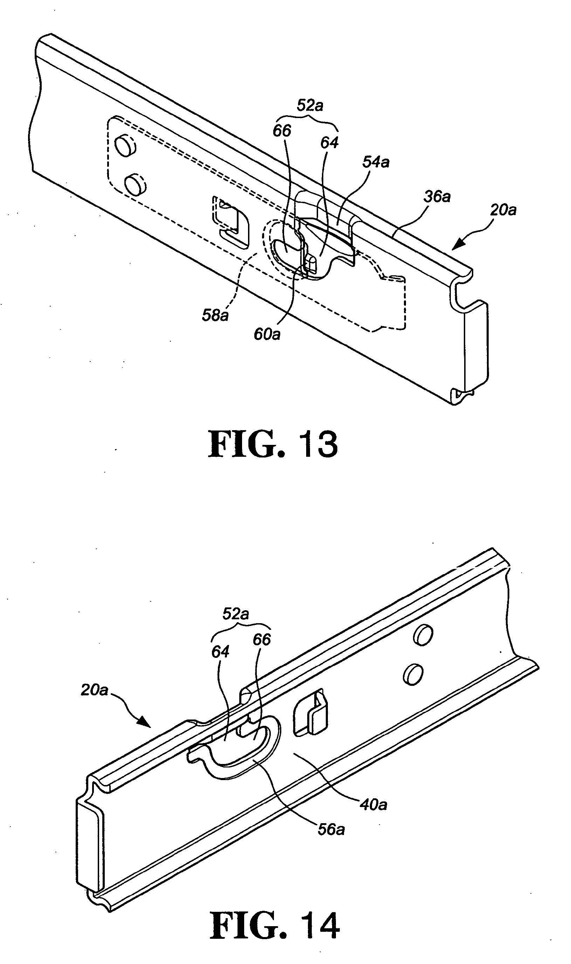

Fig. 13 shows that the hole 52a further comprises a vertical section 64 and a horizontal section 66 to form an L-shaped hole. In another embodiment, the recessed inner wall 54a extends from the vertical section 64 of the hole 52a to the top flange 36a of the inner rail 20a. The stop plate 58a on the inside of the inner rail 20a includes a stop portion 60a which is located corresponding to the horizontal section 66 of the hole 52a. Referring to Fig. 14, the recess 56a is located on the inside of the connection wall 40a of the inner rail 20a and extends along the periphery of the vertical and horizontal sections 64, 66 of the hole 52a.

The present invention does not need to have a slit in the side of the rail so that the strength of the rails can be reinforced. Especially when the sizes of the rails are not changed, the width of the chassis can be maximized and the chassis can be installed to the rack and operated safely.

While we have shown and described the embodiment in accordance with the present invention, it should be clear to those skilled in the art that further embodiments may be made without departing from the scope of the present invention.

## Claims

1. An installation system of a slide assembly (16), the sliding assembly (16) connected to a rack and a chassis (12) installed to the rack, the chassis (12) comprising a plurality of installation members (14) each having a head (26), the slide assembly (16) comprising an outer rail (18); an inner rail (20) longitudinally and slidably movable relative to the outer rail (18), the inner rail (20) having a top flange (36), a bottom flange (38) which is located opposite to the top flange (36) and a connection wall (40) connected between the top and bottom flanges (36, 38); and a plurality of engaging portions (50) located in the inner rail (20), each of the plurality of engaging portions (50) having a hole (52) defined in the connection wall (40) of the inner rail (20), and **characterized by**:
a recess (56) defined in an inside of the connection wall (40) of the inner rail (20) and formed along the hole (52) of one of the plurality of engaging portions (50) by extending along the periphery of the hole (52);
a stop plate (58) connected to the inside of the connection wall (40) of the inner rail (20) and located corresponding to one of the plurality of engaging portions (50) of the inner rail (20), the stop plate (58) having a stop portion (60) which is located corresponding to the hole (52) of one of the plurality of engaging portions (50);
wherein the head (26) of the installation member (14) of the chassis (12) is partially inserted into the recess (56) at the hole (52) of the inside of the connection wall (40) and the head (26) is stopped by the stop portion (60) of the stop plate (58).

2. The installation system as claimed in claim 1, further comprising a middle rail (22) movably connected between the inner and outer rails (18, 20), a first carriage (28) movably connected between the middle rail (22) and the inner rail (20), a first ball assembly (30) connected to the first carriage (28), a second carriage (32) movably connected between the middle rail (22) and the outer rail (18), a second ball assembly (34) connected to the second carriage (32), wherein the first ball assembly (30) of the first carriage (28) is movably connected between the top flange (36) and the bottom flange (38) of the inner rail (20).

3. The installation system as claimed in claim 1, wherein the plurality of engaging portions (50) each have a recessed inner wall (54) defined in the inner rail (20) and extending from the hole (52) to the top flange (36), such that the head (26) of the relative installation member (14) of the chassis (12) is engaged with the hole (52) of the inside of the connection wall (40) via the recessed inner wall (54) of the inner rail (20).

4. The installation system as claimed in claim 3, wherein the stop plate (58) includes a guiding portion (62) located corresponding to the recessed inner wall (54).

## Patentansprüche

1. Ein Einbaumechanismus einer Gleitschiene (16), wobei diese Gleitschiene (16) an ein Gestell und an einen an diesem Gestell montierten Träger (12) befestigt ist; der Träger (12) aus mehreren Installationselementen (14) besteht, wobei alle Installationselemente (14) ein Kopfteil (26) aufweisen; die Gleitschiene (16) aus einer äußeren Schiene (18), einer inneren Schiene (20), die der Länge nach und gleitbar an der äußeren Schiene (18) angeordnet ist, besteht; die innere Schiene (20) einen oberen Flansch (36), einen unteren Flansch (38) gegenüber dem oberen Flansch (36), und eine Verbindungswand (40) aufweist, wobei die Verbindungswand (40) zwischen dem oberen und unteren Flansch (36, 38) gebildet ist; und mehrere Einrückteile (50) an der inneren Schiene (20) geformt sind, wobei jedes dieser mehreren Einrückteile (50) mit einer Öffnung (52) in der Verbindungswand (40) der inneren Schiene (20) versehen sind, und **dadurch gekennzeichnet, dass**:
eine Auskehlung (56) auf einer Innenseite der Verbindungswand (40) der inneren Schiene (20) gebildet und entlang der Öffnung (52) eines der mehreren Einrückteile (50) geformt ist;
eine Anschlagplatte (58) auf der Innenseite der Verbindungswand (40) der inneren Schiene (20) befestigt und entsprechend eines der mehreren Einrückteile (50) der inneren Schiene (20) angeordnet ist; die Anschlagplatte (58) mit einem Anschlagteil (60) versehen ist, das entsprechend der Öffnung (52) eines der mehreren Einrückteile (50) angeordnet ist;
**dadurch gekennzeichnet, dass** das Kopfteil (26) des Installationselements (14) am Träger (12) in die Auskehlung (56) an der Öffnung (52) auf der Innenseite der Verbindungswand (40) eingerückt ist, wobei das Kopfteil (26) an das Anschlagteil (60) der Anschlagplatte (58) anstößt.

2. Der Einbaumechanismus nach Anspruch 1, weiter bestehend aus einer mittigen Schiene (22), die beweglich zwischen der inneren und äußeren Schiene (18, 20) befestigt ist; zwischen der mittigen Schiene (22) und der inneren Schiene (20) ein erster Schitten (28) beweglich montiert ist; ein erster Kugelmechanismus (30) am ersten Schlitten (28) befestigt ist; ein zweiter Schlitten (32) beweglich zwischen der mittigen Schiene (22) und der äußeren Schiene (18) befestigt ist; ein zweiter Kugelmechanismus (34) am zweiten Schlitten (32) befestigt ist, während der erste Kugelmechanismus (30) des ersten Schlittens (28) beweglich zwischen dem oberen Flansch (36) und dem unteren Flansch (38) der inneren Schiene (20) befestigt ist.

3. Der Einbaumechanismus nach Anspruch 1, **dadurch gekennzeichnet, dass** die mehreren Einrückteile (50) je eine ausgekehlte Innenwand (54) aufweist, die in der inneren Schiene (20) gebildet sind und aus der Öffnung (52) zum oberen Flansch (36) ragen, damit das Kopfteil (26) des jeweiligen Installationselements (14) am Träger (12) durch die ausgekehlte Innenwand (54) der inneren Schiene (20) in die Öffnung (52) auf der Innenseite der Verbindungswand (40) einrückt.

4. Der Einbaumechanismus nach Anspruch 3, **dadurch gekennzeichnet, dass** die Anschlagplatte (58) aus einem Führungselement (62) besteht, das nach der ausgekehlten Innenwand (54) ausgerichtet ist.

## Revendications

1. Un système d'installation d'un ensemble coulissant (16), l'ensemble coulissant (16) relié à un rack et un châssis (12) installé sur le rack, le châssis (12) comprenant une pluralité d'éléments d'installation (14) ayant chacun une tête (26), l'ensemble coulissant (16) comprenant un rail extérieur (18) ; un rail intérieur (20) déplaçable de façon longitudinale et glissante par rapport au rail extérieur (18), le rail intérieur (20) ayant une bride supérieure (36), une bride inférieure (38) située à l'opposé de la bride supérieure (36) et une paroi de connexion (40) reliée entre la bride supérieure et celle inférieure (36, 38) ; et une pluralité de parties d'engagement (50) situées dans le rail intérieur (20), chacune des parties d'engagement (50) ayant un trou (52) défini dans la paroi de connexion (40) du rail intérieur (20), et **caractérisé par** :
un renfoncement (56) défini dans l'intérieur de la paroi de connexion (40) du rail intérieur (20) et formé le long du trou (52) d'une des parties d'engagement (50) ;
une plaque de butée (58) reliée à l'intérieur de la paroi de connexion (40) du rail intérieur (20) et située en correspondance avec l'une des parties d'engagement (50) du rail intérieur (20), la plaque de butée (58) ayant une partie de butée (60) située en correspondance avec le trou (52) de l'une des parties d'engagement (50) ;
où la tête (26) de l'élément d'installation (14) du châssis (12) est engagée avec le renfoncement (56) au trou (52) de l'intérieur de la paroi de connexion (40) et la tête (26) est arrêtée par la partie de butée (60) de la plaque de butée (58).

2. Le système d'installation tel que revendiqué dans la revendication 1, comprenant en outre un rail intemédiaire (22) relié de façon amovible entre le rail intérieur et celui extérieur (18, 20), un premier élément de déplacement (28) relié de façon amovible entre le rail intermédiaire (22) et le rail intérieur (20), un premier assemblage de billes (30) relié au premier élément de déplacement (28), un deuxième élément de déplacement (32) relié de façon amovible entre le rail intermédiaire (22) et le rail extérieur (18), un deuxième assemblage de billes (34) relié au deuxième élément de déplacement (32), où le premier assemblage de billes (30) du premier élément de déplacement (28) est relié de façon amovible entre la bride supérieure (36) et la bride inférieure (38) du rail intérieur (20).

3. Le système d'installation tel que revendiqué dans la revendication 1, où les parties d'engagement (50) ont chacune une paroi intérieure en renfoncement (54) définie dans le rail intérieur (20) et s'étendant du trou (52) à la bride supérieure (36), de sorte que la tête (26) de l'élément d'installation correspondant (14) du châssis (12) est engagé avec le trou (52) de l'intérieur de la paroi de connexion (40) via la paroi intérieure en renfoncement (54) du rail intérieur (20).

4. Le système d'installation tel que revendiqué dans la revendication 3, où la plaque de butée (58) inclut une partie de guidage (62) située en correspondance avec la paroi intérieure en renfoncement (54).
